(19) Europäisches Patentamt
European Patent Office
Office européen des brevets

(11) **EP 2 662 331 B1**

(12) **EUROPEAN PATENT SPECIFICATION**

(45) Date of publication and mention
of the grant of the patent:
**28.06.2017   Bulletin 2017/26**

(51) Int Cl.:
*C01B 19/00* (2006.01)     *H01L 35/16* (2006.01)
*H01L 35/28* (2006.01)

(21) Application number: **13150057.1**

(22) Date of filing: **02.01.2013**

(54) **Thermoelectric material, and thermoelectric module and thermoelectric apparatus including the thermoelectric material**

Thermoelektrisches Material und thermoelektrisches Modul und thermoelektrische Vorrichtung mit dem thermoelektrischen Material

Matériau thermoélectrique et module thermoélectrique et appareil thermoélectrique comprenant le matériau thermoélectrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **10.05.2012   KR 20120049774**

(43) Date of publication of application:
**13.11.2013   Bulletin 2013/46**

(73) Proprietor: **Samsung Electronics Co., Ltd
Gyeonggi-do 443-742 (KR)**

(72) Inventors:
 • **Ahn, Kyung-han**
   **Gyeonggi-do 449-712 (KR)**
 • **Kim, Sang-il**
   **Gyeonggi-do 449-712 (KR)**
 • **Ryu, Byung-ki**
   **Gyeonggi-do 449-712 (KR)**
 • **Lee, Kyu-hyoung**
   **Gyeonggi-do 449-712 (KR)**
 • **Hwang, Sung-woo**
   **Gyeonggi-do 449-712 (KR)**

(74) Representative: **Zijlstra, Robert Wiebo Johan
Elkington and Fife LLP
Prospect House
8 Pembroke Road
Sevenoaks, Kent TN13 1XR (GB)**

(56) References cited:
**CN-A- 1 718 811     CN-A- 101 082 114
US-A- 5 726 381**

• **DATABASE CA [Online] CHEMICAL ABSTRACTS SERVICE, COLUMBUS, OHIO, US; 31 March 2011 (2011-03-31), SHEN, JUN-JIE ET AL: "Influence of Ag2Te doping on the thermoelectric properties of p-type Bi0.5Sb1.5Te3 bulk alloys", XP002743860, retrieved from STN Database accession no. 154:348847 & SHEN, JUN-JIE ET AL: "Influence of Ag2Te doping on the thermoelectric properties of p-type Bi0.5Sb1.5Te3 bulk alloys", WUJI CAILIAO XUEBAO , 25(6), 583-587 CODEN: WCXUET; ISSN: 1000-324X, 2010, DOI: 10.3724/SP.J.1077.2010.00583**

**Description**

BACKGROUND OF THE INVENTION

The present disclosure relates to a thermoelectric material, and a thermoelectric module and a thermoelectric apparatus including the thermoelectric material, and more particularly, to a thermoelectric material having an increased power factor and a thermoelectric module and a thermoelectric apparatus including the thermoelectric material.

The thermoelectric effect is a reversible and direct energy conversion between heat and electricity, and is generated by movement of phonons due to movement of electrons and holes within a material. The thermoelectric effect may be classified as a Peltier effect and a Seebeck effect, wherein the Peltier effect provides cooling using a temperature difference between ends of a thermoelectric material generated by an applied current, and the Seebeck effect provides power generated using an electromotive force generated by a temperature difference between ends of a thermoelectric material.

The thermoelectric material is applied to an active type cooling system of semiconductor equipment and electronic devices in which suitable thermal management difficult to provide using a passive type cooling system. Demand for thermoelectric cooling is expanding into other cooling applications, where suitable heat removal is difficult using a gas compression-type system. Thermoelectric cooling is an environmentally friendly cooling technology with no-vibration and low-noise, and avoids the use of a refrigerant gas that may cause environmental problems. The application range of thermoelectric cooling may be expanded into general-purpose cooling, such as refrigerators and air conditioners if thermoelectric cooling efficiency is improved by the development of a more efficient thermoelectric cooling material. In addition, when the thermoelectric material is applied to a location where heat is released, such as in an engine or in an industrial plant, electricity may be generated by a temperature difference generated between ends of the material. Thus, the technology is highlighted as a new renewable energy source. Nonetheless, there remains a need for an improved thermoelectric material.

US 5,5726,381 discloses amorphous thermoelectric alloys and corresponding thermoelectric couples. The allous can thereby contain transition metals and/or rare earth metals

Shen et al. (Journal of Inorganic Materials, 2010, 25(6), 583-587) disclose silver doped $Bi_{0.5}Sb_{1.5}Te_3$ alloys.

CN 101082114A discloses copper doped $Bi_{0.5}Sb_{15}Te_3$ alloys.

SUMMARY OF THE INVENTION

Provided is a thermoelectric material having an improved power factor due to distortion of an electronic density of states.

Provided is a thermoelectric module including the thermoelectric material.

Provided is a thermoelectric apparatus including the thermoelectric module.

Additional aspects will be set forth in part in the description which follows and, in part, will be apparent from the description.

According to an aspect, disclosed is a thermoelectric material including a composition of Formula 1:

$$\text{Formula 1} \qquad (Bi_{1-x-z}Sb_xA_z)_u(Te_{1-y}Se_y)_w,$$

wherein A is a transition metal, $0 \leq x < 1$, $0 \leq y \leq 1$, $0.005 < z \leq 0.02$, $1.8 \leq u \leq 2.2$, and $2.8 \leq w \leq 3.2$.

The component A may include at least one selected from Mn and Fe.

The thermoelectric material may have a charge density of $1 \times 10^{19}$ cm$^{-3}$ to $10 \times 10^{19}$ cm$^{-3}$ at 300 K.

The thermoelectric material may be a sintered body or a powder.

According to another aspect, disclosed is a thermoelectric module including a first electrode, a second electrode, and the thermoelectric element between the first and second electrodes.

Also provided is a thermoelectric apparatus including: a heat supply source; and a thermoelectric module, wherein the thermoelectric module includes a thermoelectric element which absorbs heat from the heat supply source, a first electrode which contacts the thermoelectric element, and a second electrode which faces the first electrode and contacts the thermoelectric element, wherein the thermoelectric element includes the thermoelectric material.

Also disclosed is a method of manufacturing a thermoelectric material, the method including: providing a combination including Bi, Sb, A, Te, and optionally Se in a molar ratio suitable to provide a composition of Formula 1:

$$\text{Formula 1} \qquad (Bi_{1-x-z}Sb_xA_z)_u(Te_{1-y}Se_y)_w,$$

wherein A is a transition metal, $0 \leq x < 1$, $0 \leq y \leq 1$, $0.005 < z \leq 0.02$, $1.8 \leq u \leq 2.2$, and $2.8 \leq w \leq 3.2$; and thermally treating the combination to manufacture the thermoelectric material.

BRIEF DESCRIPTION OF THE DRAWINGS

These and/or other aspects will become apparent and more readily appreciated from the following description of the embodiments, taken in conjunction with the accompanying drawings in which:

FIG. 1 illustrates an embodiment of a thermoelectric module;
FIG. 2 is a schematic diagram of an embodiment of a thermoelectric module, which shows thermoelectric cooling according to a Peltier effect;
FIG. 3 is a schematic diagram of an embodiment of a thermoelectric module, which shows thermoelectric power generation according to a Seebeck effect;
FIG. 4 is a graph of electrical conductivity (Siemens per centimeter, S/cm) versus temperature (Kelvin, K) showing results of measuring the electrical conductivity of the thermoelectric materials obtained in Examples 1-1 to 1-7 and Comparative Example 1;
FIG. 5 is a graph of Seebeck coefficient (microvolts per Kelvin, $\mu$V/K) versus temperature (Kelvin, K) showing the results of measuring the Seebeck coefficient of the thermoelectric materials obtained in Examples 1-1 to 1-5 and Comparative Example 1;
FIG. 6 is a graph of power factor (microwatts per centimeter-square Kelvin, $\mu$W/cmK$^2$) versus temperature (Kelvin, K) showing the results of measuring the power factor of the thermoelectric materials obtained in Examples 1-1 to 1-5 and Comparative Example 1;
FIG. 7 is a graph of electrical conductivity (Siemens per centimeter, S/cm) versus temperature (Kelvin, K) showing the results of measuring the electrical conductivity of the thermoelectric materials obtained in Examples 2-1 to 2-5 and Comparative Example 1;
FIG. 8 is a graph of Seebeck coefficient (microvolts per Kelvin, $\mu$V/K) versus temperature (Kelvin, K) showing the results of measuring the Seebeck coefficient of the thermoelectric materials obtained in Examples 2-1 to 2-3 and 2-5, and Comparative Example 1;
FIG. 9 is a graph of power factor (microWatts per centimeter-square Kelvin, $\mu$W/cmK$^2$) versus temperature (Kelvin, K) showing results of measuring the power factor of the thermoelectric materials obtained in Examples 2-1 to 2-3 and 2-5 and Comparative Example 1; and
FIG. 10 is a graph of Seebeck coefficient (microvolts per Kelvin, $\mu$V/K) versus carrier density ($10^{19}$ carriers per cubic centimeter, $10^{19}$cm$^{-3}$) showing Seebeck coefficients according to carrier densities of the thermoelectric materials obtained in Examples 1 and 2.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one," when preceding a list of elements, modify the entire list of elements and do not modify the individual elements of the list.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms "first," "second," "third" etc. may be used herein to describe various elements, components, regions, layers, and/or sections, these elements, components, regions, layers, and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "one or more" unless the content clearly indicates otherwise. "Or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

A transition metal is an element of Groups 3 to 12 of the Periodic Table of the Elements.

A thermoelectric material comprising a composition of Formula 1 may have improved thermoelectric performance.

$$\text{Formula 1} \qquad (Bi_{1-x-z}Sb_xA_z)_u(Te_{1-y}Se_y)_w$$

In Formula 1, A is a transition metal, $0 \leq x < 1$, $0 \leq y \leq 1$, $0.005 < z \leq 0.02$, $1.8 \leq u \leq 2.2$, and $2.8 \leq w \leq 3.2$. While not wanting to be bound by theory, it is understood that the improved thermoelectric performance is provided by an increased a power factor, which is improved by adding a component A to the composition of Formula 1.

While not wanting to be bound by theory, it is understood that the power factor of the thermoelectric material may be increased due to distortion of the electronic density of states by partially substituting or doping a component using a different element which may be a transition metal. In an embodiment, the different element substitutes for Bi. The distortion of electronic density of states is understood to cause a level of a Fermi energy to be shifted in a direction of increased effective mass. As a result, a Seebeck coefficient increases, and thus high thermoelectric performance may be obtained.

The performance of a thermoelectric material is evaluated using a ZT value in the following Equation 1, commonly known as a dimensionless figure of merit.

$$\text{Equation 1}$$
$$ZT = (S^2 \sigma T) / k$$

In Equation 1, Z is a figure of merit, S is a Seebeck coefficient, $\sigma$ is an electrical conductivity, T is absolute temperature, and k is a thermal conductivity.

As shown in Equation 1, the Seebeck coefficient and electrical conductivity, that is, a power factor ($S^2\sigma$), should be increased and the electrical conductivity should be decreased in order to increase a ZT value of a thermoelectric material. However, the Seebeck coefficient and electrical conductivity have a trade-off relationship where one of the values is decreased when the other is increased, as can be provided by variations in the concentration of a carrier, e.g., electrons or holes, and thus, there are significant limitations in increasing the power factor.

Using nano-structure technology, superlattice thin films, nanowires, and quantum dots, may be fabricated, and it is understood that a Seebeck coefficient may be increased in these materials by quantum confinement effects, or thermal conductivity may be decreased by a phonon glass electron crystal (PGEC) concept, to provide improved thermoelectric performance.

While not wanting to be bound by theory, the quantum confinement effect provides that an increase in the carrier density in a material results in an increase an effective mass, and increases a Seebeck coefficient without significantly changing the electrical conductivity, and thus collapses the trade-off relationship between electrical conductivity and Seebeck coefficient. The PGEC concept provides that the movement of phonons responsible for heat transfer may be blocked without inhibiting the movement of carriers to lower the thermal conductivity only. However, most of the high-performance nano-structured materials that have been developed are available only in the form of a thin film, and thus commercialization of the material is difficult, in part due to limitations of bulk-making technology.

It is thus understood that the thermoelectric material having the composition of Formula 1 enables a power factor to be increased by shifting a level of the Fermi energy to near that of the electronic density of states that is distorted through substituting or doping with a different element. This method of increasing power factor is different than the nano-structuring method.

While not wanting to be bound by theory, it is understood that if a (Bi,Sb)(Te,Se)-based thermoelectric material is substituted and/or doped with a selected content of a transition metal, the transition metal may be substituted for bismuth (Bi) and/or antimony (Sb), and the electronic density of states in the thermoelectric material may be distorted. Consequently, an electrical conductivity, a Seebeck coefficient, and a power factor of the thermoelectric material may be changed due to a shift in the Fermi energy level according to the distortion of the electronic density of states and the change in charge density. Therefore, thermoelectric performance may be increased by increasing the power factor by shifting the level of the Fermi energy of the thermoelectric material to provide the distortion of the electric density of states.

According to an embodiment, the (Bi,Sb)(Te,Se)-based thermoelectric material including the selected content of the transition metal A includes a material having a composition of the following Formula 1.

$$\text{Formula 1} \qquad (Bi_{1-x-z}Sb_xA_z)_u(Te_{1-y}Se_y)_w$$

In Formula 1, A is a transition metal, $0 \leq x < 1$, $0 \leq y \leq 1$, $0.005 < z \leq 0.02$, $1.8 \leq u \leq 2.2$, and $2.8 \leq w \leq 3.2$.

A thermoelectric material of Formula 1 may include a thermoelectric material of the following Formula 2.

$$\text{Formula 2} \qquad (Bi_{1-x-z}Sb_xA_z)_u(Te_{1-y}Se_y)_w$$

In Formula 2, A is a transition metal, $0 \leq x \leq 0.999$, $0 \leq y \leq 1$, $0.005 \leq z \leq 0.02$, $1.8 \leq u \leq 2.2$, and $2.8 \leq w \leq 3.2$.

In an embodiment, $0.001 \leq x \leq 0.999$, specifically $0.01 \leq x \leq 0.99$, more specifically $0.1 \leq x \leq 0.9$.

In an embodiment, $0.1 \leq y \leq 0.9$, specifically $0.2 \leq y \leq 0.8$, more specifically $0.2 \leq y \leq 0.7$.

In an embodiment, $0.01 \leq z \leq 0.02$, more specifically $0.012 \leq z \leq 0.018$.

In an embodiment, $1.85 \leq u \leq 2.15$, specifically $1.9 \leq u \leq 2.1$.

In an embodiment, $2.85 \leq w \leq 3.15$, specifically $2.9 \leq w \leq 3.1$, more specifically $2.95 \leq w \leq 3.05$.

According to an embodiment, A may be at least one selected from Ni, Zn, Sc, Y, Ti, Zr, Hf, V, Nb, Ta, Cr, Mo, W, Mn, Fe, Co, and Re, specifically at least one selected from Mn, Fe, Co, and Re, more specifically at least one selected from Fe and Re. The component A may be substituted and/or doped in the (Bi,Sb)(Te,Se)-based thermoelectric material. The component A is not limited thereto, and in an embodiment may be a transition metal. For example, Mn, Fe may be used as the transition metal.

A content (z) of the component A for substituting and/or doping (Bi,Sb)(Te,Se)-based thermoelectric material may be 0.5 mol % to 1.5 mol % ($0.005 \leq z \leq 0.015$), based on the total amount of Bi and Sb (if present). A content of the component A within the foregoing range may sufficiently distort electronic density of states of a (Bi,Sb)(Te,Se)-based thermoelectric material.

Alternatively, a content of the component A may be expressed as a molar ratio to all elements. A content (z) of the component A for substituting and/or doping (Bi,Sb)(Te,Se)-based thermoelectric material may be 0.2 mol % to 0.2 mol %, or 0.02 mol % to 1.5 mol %, based on the total amount of all the elements of the thermoelectric material. A content of the component A within the foregoing range may sufficiently distort the electronic density of states of a (Bi,Sb)(Te,Se)-based thermoelectric material.

The thermoelectric apparatus according to an embodiment may further include a power supply source that is electrically connected to the first and second electrodes.

A content of Sb in the (Bi,Sb)(Te,Se)-based thermoelectric material may be less than 100 mol %, for example, 99.9 mol % or less, specifically 0.1 mol % to 80 mol %, more specifically 0.1 mol % to 50 mol %, based on the total amount of the component A, Bi, and Sb.

Alternatively, a content of Sb may be expressed as a molar ratio to all elements. A content of Sb in the (Bi,Sb)(Te,Se)-based thermoelectric material may be 40 mol % or less, for example, 39.96 mol % or less, specifically 0.04 mol % to 32 mol %, more specifically 0.04 mol % to 20 mol %, based on the total amount of all of the elements of the thermoelectric material.

A content of Se in the (Bi,Sb)(Te,Se)-based thermoelectric material may be 100 mol % or less, for example, 99.9 mol % or less, specifically 0.1 mol % to 80 mol %, more specifically 0.1 mol % to 50 mol %, based on the total amount of Te and Se.

Alternatively, a content of Sb may be expressed as a molar ratio to all elements. A content of Se in the (Bi,Sb)(Te,Se)-based thermoelectric material may be 60 mol % or less, for example, 59.94 mol % or less, specifically 0.06 mol % to 48 mol %, more specifically 0.06 mol % to 30 mol %, based on the total amount of all the elements of the thermoelectric material.

A power factor (a Seebeck coefficient$^2$ x an electrical conductivity) of a thermoelectric material having the composition above is increased, for example, at room temperature, and thus, the increase in the power factor provides an improvement in thermoelectric performance, for example, at room temperature.

According to an embodiment, a thermoelectric material with a high ZT value may be implemented at any suitable temperature. The temperature may be 600 K or less, for example, 550 K or less, specifically 400 K or less. For example, the temperature may be in a range of 200 K to 400 K, specifically 250 K to 350 K.

According to an embodiment, a thermoelectric material including a compound represented by Formula 1 may have a charge density of $1\times10^{18}$ cm$^{-3}$ to $10\times10^{20}$ cm$^{-3}$, specifically $1\times10^{19}$ cm$^{-3}$ to $10\times10^{19}$ cm$^{-3}$, more specifically $3\times10^{19}$ cm$^{-3}$ to $7\times10^{19}$ cm$^{-3}$, at room temperature, for example, at 300 K.

According to an embodiment, a thermoelectric material including a compound represented by Formula 1 may have a power factor of 35 $\mu$W/cm·K$^2$ or more, for example 40 $\mu$W/cm·K$^2$ to 50 $\mu$W/cm·K$^2$ at room temperature, for example, at 300 K.

Also, a thermoelectric material including a compound represented by Formula 1 may have a ZT value of 0.9 or greater at room temperature, for example, at 300 K. The ZT value may be 1.0 or greater, or 1.1 or greater at room temperature.

A thermoelectric material according to an embodiment may be in the form of a powder or a sintered body, for example a bulk shape or a bulk material. Also, a thermoelectric material may have a crystalline structure. The crystalline structure may be a polycrystalline or a single crystal structure. In another embodiment the thermoelectric material may be amorphous.

A thermoelectric material may be prepared using one of the following methods, but is not limited thereto:

(1) A method using an ampoule: the method including disposing a raw material in a quartz tube or metal ampoule, and sealing and thermally-treating the quartz tube or metal ampoule in vacuum.
(2) An arc melting method: the method including disposing a raw material in a chamber and preparing a sample by melting the raw material by arc discharging under an inert gas atmosphere.
(3) A solid state reaction method: the method including thermally-treating a powder after mixing and hardening the powder or processing and sintering the mixed powder after thermal-treating the mixed powder.

A thermoelectric material having a single crystalline structure may be prepared by the following methods, but is not limited thereto:

(1) A metal flux method: the method including disposing a raw material and an element for providing an atmosphere for satisfactorily growing the raw material to a crystal at a high temperature into a crucible, and thermally-treating the raw material and the element at a high temperature to grow a crystal.
(2) A Bridgman method: the method including disposing a raw material into a crucible, heating an end of the crucible at a high temperature until the raw material is dissolved, and then growing a crystal by locally dissolving a sample by slowly moving a high temperature region, and passing the entire sample through the high temperature region.
(3) A zone melting method: the method including providing a raw material in the form of a seed rod and a feed rod, and growing a crystal by locally heating the seed rod and the feed rod at a high temperature to melt a sample while slowly moving a molten portion upward.
(4) A vapor transport method: the method including disposing a raw material at a bottom of a quartz tube and heating the bottom of the quartz tube where the raw material is while leaving a top of the quartz tube at a lower temperature so that a crystal is grown as the raw material is vaporized.

A thermoelectric material according to an embodiment may be prepared by using any of the above methods.

A densification process may be additionally performed on a polycrystalline composition. An electrical conductivity may be additionally improved through the densification process.

The three following processes may be examples of the densification process.

(1) A hot pressing method: the method including disposing a powder of a compound, which is a target material, on a mold of a predetermined shape and molding the material at a high temperature, e.g., at 300°C to 800°C, specifically 400°C to 700°C, and at a pressure of, for example, 30 megaPascals (MPa) to 300 MPa, specifically 60 MPa to 200 MPa.
(2) A spark plasma sintering method: the method including sintering a powder of a compound, which is a target material, in a short period of time by inducing a high voltage and/or current to the target material under conditions of high pressure in a range of, for example, 30 MPa to 300 MPa, specifically 60 MPa to 200 MPa, and a current of 50 amperes (A) to 500 A, specifically 100 amperes (A) to 400 A.

(3) A hot pressing method: the method including extrusion sintering by increasing a temperature of a powder, which is a target material, to for example, 300°C to 700°C, specifically 400°C to 600°C during a press-molding process.

The thermoelectric material may have a density of 70 % to 100 %, specifically 80% to 99%, of a theoretical density due to the densification process. The theoretical density may be calculated by dividing a molecular weight by an atomic volume and may be evaluated by a lattice parameter. For example, the thermoelectric material may have a density of, for example, 95 % to 100 %, based on a theoretical density, and thus may have an increased electrical conductivity.

According to another embodiment, a thermoelectric element is obtained by molding the thermoelectric material, or by cutting the thermoelectric material.

The thermoelectric element may be a p-type or n-type thermoelectric element. The thermoelectric element refers to the thermoelectric material that is shaped to a selected shape, for example, a rectangular parallelepiped shape. The shape of the thermoelectric element may be any suitable shape, and may be rectilinear, e.g., rectangular.

The thermoelectric element may be combined with an electrode to provide a cooling effect upon application of electrical current application, or to generate power from a temperature difference across the thermoelectric element.

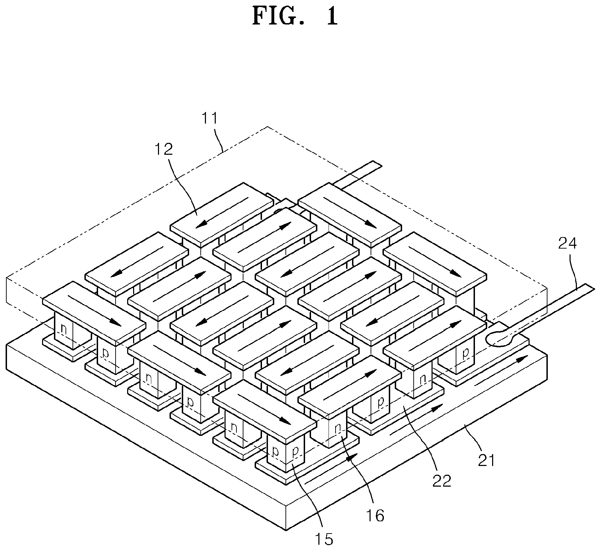

FIG. 1 is an example of a thermoelectric module including the thermoelectric element. As shown in FIG. 1, an upper electrode 12 and a lower electrode 22 are patterned respectively on an upper insulating substrate 11 and a lower insulating substrate 21, and a p-type thermoelectric element 15 and an n-type thermoelectric element 16 mutually contact the upper electrode 12 and the lower electrode 22. The upper and lower electrodes 22 are electrically connected to the outside of the thermoelectric module via a lead electrode 24.

The upper and lower insulating substrates 11 and 21 may comprise at least one selected from gallium arsenic (GaAs), sapphire, silicon, PYREX, and quartz. Also, the upper and lower electrodes 12 and 22 may comprise at least one selected from aluminum, nickel, gold, and titanium. The upper and lower electrodes may have any suitable size. The upper and lower electrodes 12 and 22 may be patterned using any suitable patterning method, such as a lift-off semiconductor method, a deposition method, or a photolithography method.

Alternatively, a thermoelectric module may include a first electrode, a second electrode, and the thermoelectric material of Formula 1 between the first and second electrodes. The thermoelectric module may further include an insulating substrate on which at least one of the first and second electrodes is disposed. The insulating substrate may be one of the upper and lower insulating substrates 11 and 21 as shown in FIG. 1.

In a thermoelectric module according to an embodiment, the first and second electrodes may be electrically connected to a power supply source.

As shown in FIG. 1, a thermoelectric module according to an embodiment may include a p-type thermoelectric element and an n-type thermoelectric element that are alternately arranged, wherein at least one of the p-type thermoelectric element and the n-type thermoelectric element includes the thermoelectric material into which nano-inclusions are inserted.

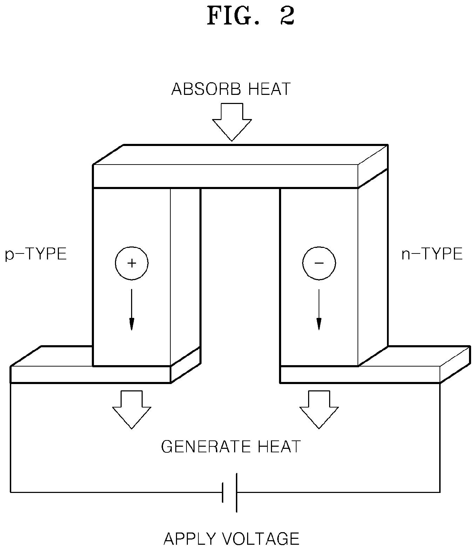

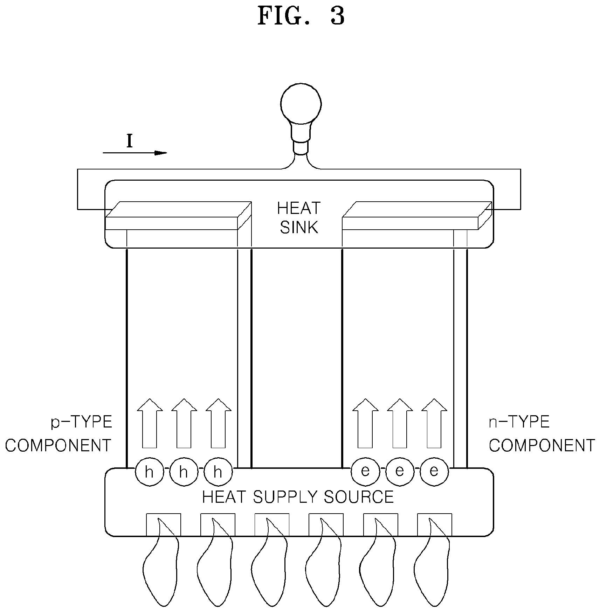

In an embodiment of the thermoelectric module, one of the first electrode and the second electrode may be exposed to a heat supply source as disclosed in FIGS. 2 and 3. In an embodiment of the thermoelectric module, one of the first electrode and the second electrode may be electrically connected to a power supply source as disclosed in FIG. 2, or electrically connected to the outside of a thermoelectric module, for example, an electric device (for example, battery) which consumes or stores electric power, as disclosed in FIG. 3.

In an embodiment of the thermoelectric module, one of the first electrode and the second electrode may be electrically connected to a power supply source as shown in FIG. 2.

In an embodiment of the thermoelectric module, the p-type thermoelectric device and the n-type thermoelectric device may be alternately arranged as shown in FIG. 2, and at least one of the p-type thermoelectric device and the n-type thermoelectric device may include a thermoelectric material including a compound of Formula 1.

According to an embodiment, there is provided a thermoelectric apparatus including a heat supply source and the thermoelectric module, wherein the thermoelectric module absorbs heat from the heat supply source and includes the thermoelectric material disclosed above, a first electrode, and a second electrode, wherein the first and second electrodes face each other. One of the first and second electrodes may contact the thermoelectric material.

The thermoelectric apparatus according to an embodiment may further include an electric device that is electrically connected to one of the first and second electrodes.

The thermoelectric material, the thermoelectric element, the thermoelectric module, and the thermoelectric apparatus may be used in a thermoelectric cooling system or a thermoelectric power generating system. Examples of the thermoelectric cooling system include a micro cooling system, a general-purpose cooling device, an air conditioner, and a cogeneration system, but are not limited thereto. A structure and a manufacturing method of the thermoelectric cooling system are well known to one of ordinary skill in the art and can be determined without undue experimentation, and thus, further description thereof is omitted.

The present disclosure will be described in greater detail with reference to the following examples. The following examples are for illustrative purposes only and shall limit the scope of the disclosure.

Examples

In the following Examples the compositions in which x equals 0.0025 do not fall within the scope of claim 1 and are provided for comparative purposes only.

Examples 1-1 to 1-7: Preparation of $(Bi_{0.2}Sb_{0.8})_{2-x}Mn_xTe_3$ thermoelectric material

Powders having a composition of $(Bi_{0.2}Sb_{0.8})_{2-x}Mn_xTe_3$ (x = 0.0025, 0.005, 0.006, 0.0075, 0.01, 0.015, and 0.03, corresponding to Examples 1-1 to 1-7, respectively), where Mn is added, were prepared using a melting method as follows.

First, Bi, Mn, Sb, and Te, as raw materials of $(Bi_{0.2}Sb_{0.8})_{2-x}Mn_xTe_3$, were weighed at a molar ratio according to the composition and put into a quartz tube with a diameter of 12 millimeters (mm), and the tube was sealed under $10^{-3}$ torr vacuum. The sealed tube was put into a rocking furnace, and the materials were melted at a temperature of 800°C for 10 hours and cooled to prepare an alloy ingot of the raw materials. The alloy ingot was pulverized by using a ball mill, and the pulverized alloy ingot was sorted into a powder having a size less than or equal to about 45 micrometers ($\mu$m) using a sieve (325 mesh) to obtain an initial powder.

Subsequently, a thermoelectric element having a bulk shape was prepared by press-sintering the initial powder using a spark plasma sintering method at a temperature of 480°C for 5 minutes at 70 MPa under vacuum.

Example 2: Preparation of $(Bi_{0.2}Sb_{0.8})_{2-x}Fe_xTe_3$ thermoelectric material

Powders having a composition of $(Bi_{0.2}Sb_{0.8})_{2-x}Mn_xTe_3$ (x = 0.0025, 0.0075, 0.015, 0.03, and 0.05, corresponding to Examples 2-1 to 2-5, respectively), where Fe is added, were prepared using a melting method as follows.

First, Bi, Mn, Sb, and Te, as raw materials of $(Bi_{0.2}Sb_{0.8})_{2-x}Fe_xTe_3$, were weighed at a molar ratio according to the composition and put into a quartz tube with a diameter of 12 mm, and the tube was sealed under $10^{-3}$ torr vacuum. The sealed tube was put into a rocking furnace, and the materials were melted at a temperature of 800°C for 10 hours and cooled to prepare an alloy ingot of the raw materials. The alloy ingot was pulverized by using a ball mill, and the pulverized alloy ingot was sorted into a powder having a size less than or equal to about 45 $\mu$m using a sieve (325 mesh) to obtain an initial powder.

Subsequently, a thermoelectric element having a bulk shape was prepared by press-sintering the initial powder using a spark plasma sintering method at a temperature of 480°C for 5 minutes at 70 MPa under vacuum.

Comparative Example 1: Preparation of $(Bi_{0.2}Sb_{0.8})_2Te_3$ thermoelectric material

A thermoelectric element having a bulk shape was prepared in the same manner as in Examples 1-1 to 1-7, except that Mn was not added (i.e., x=0).

Experimental Example 1

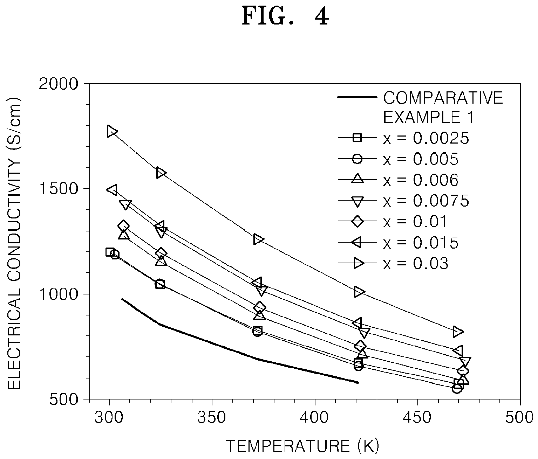

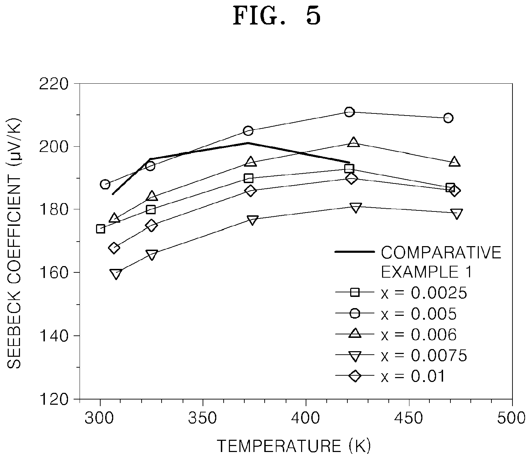

A Seebeck coefficient and an electrical conductivity of each of the thermoelectric materials prepared in Examples 1-1 to 1-7 and Comparative Example 1 were simultaneously measured by using ZEM-3 which is available from ULVAC-RIKO, Inc., and the results are respectively shown in FIGS. 4 and 5.

As shown in FIG. 4, all the thermoelectric materials obtained in Examples 1-1 to 1-7 provide improved electrical conductivity compared to the thermoelectric material obtained in Comparative Example 1. The electrical conductivities were increased up to about 80 % at room temperature (about 300 K).

As shown in FIG. 5, it may be confirmed that the thermoelectric materials obtained in Examples 1-1 to 1-7 have a Seebeck coefficient which is similar to the Seebeck coefficient of the thermoelectric material obtained in Comparative Example 1.

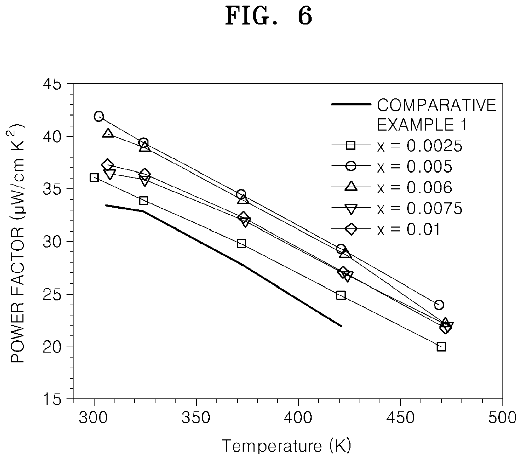

Power factors were calculated based on the electrical conductivities and the Seebeck coefficients, and the results are shown in FIG. 6. As shown in FIG. 6, the thermoelectric materials obtained in Examples 1-1 to 1-7 each have a power factor which is greater than a power factor of the thermoelectric material obtained in Comparative Example 1. The power factors were increased up to about 30 % at room temperature (about 300 K). The improved power factors of Examples 1-1 to 1-7 indicate an improvement in thermoelectric performance.

Experimental Example 2

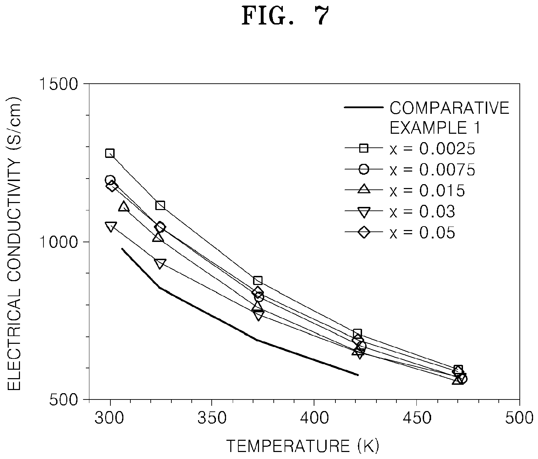

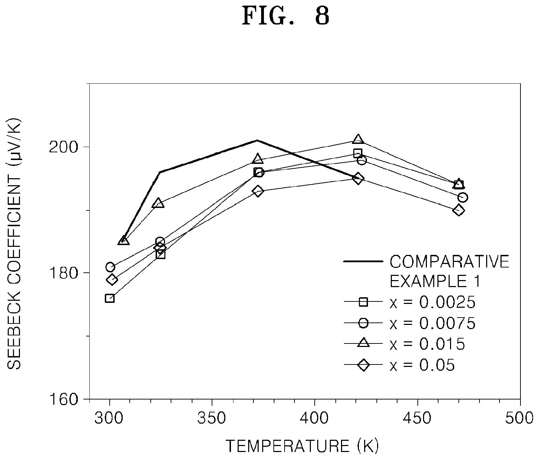

A Seebeck coefficient and an electrical conductivity of each of the thermoelectric materials prepared in Examples 2-1 to 2-5 and Comparative Example 1 were simultaneously measured by using ZEM-3 which is available from ULVAC-RIKO, Inc., and the results are respectively shown in FIGS. 7 and 8.

As shown in FIG. 7, all the thermoelectric materials obtained in Examples 2-1 to 2-5 provide improved electrical conductivity compared to the thermoelectric materials obtained in Comparative Example 1. The electrical conductivities were increased up to about 30 % at room temperature (about 300 K).

As shown in FIG. 8, it may be confirmed that the thermoelectric materials obtained in Examples 2-1 to 2-3 and 2-5 have Seebeck coefficients which are similar to the Seebeck coefficients of the thermoelectric materials obtained in Comparative Example 1.

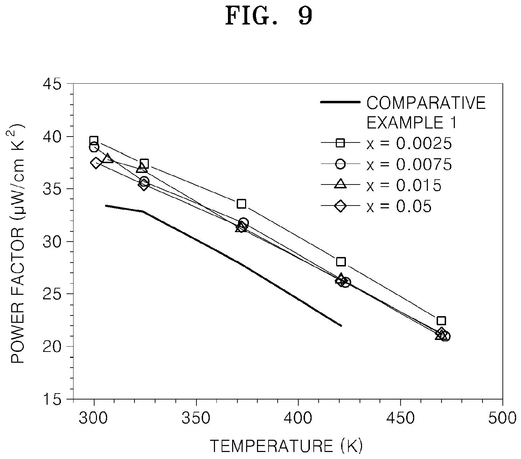

Power factors were calculated based on the electrical conductivities and the Seebeck coefficients, and the results are shown in FIG. 9. As shown in FIG. 9, the thermoelectric materials obtained in Examples 2-1 to 2-3 and 2-5 have increased power factors compared to the thermoelectric materials obtained in Comparative Example 1. The power factors were increased up to about 20 % at room temperature. The improved power factors indicate an improvement of thermoelectric performance.

Such an improvement of thermoelectric performance is understood to be obtained by substituting and/or doping Mn or Fe to distort the electronic density of states of the thermoelectric material and selecting a level of the Fermi energy of the thermoelectric material to have a distorted electronic density of states.

Experimental Example 3

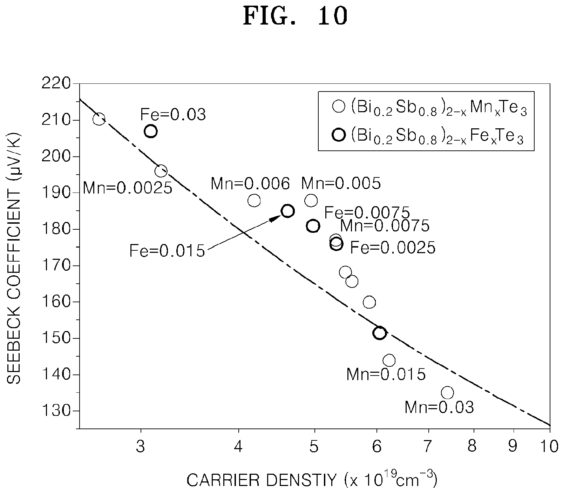

A carrier density of each of the thermoelectric materials obtained in Examples 1-1 to 1-7 and 2-1 to 2-5 and Comparative Example 1 was measured, and the results are shown in FIG. 10 along with the Seebeck coefficients. A dashed line in FIG. 10 represents a Pisarenko line. Unlike the thermoelectric materials not showing distortion of the electronic density of states and which are distributed along the line, the thermoelectric materials prepared in Examples 1-1 to 1-7 and 2-1 to 2-5 are distributed off the line, indicating the distortion of the electronic density of states in these materials. Thus it may be confirmed that the Seebeck coefficients were increased through the distortion of electronic density of states.

Therefore, as shown in FIG. 10, the thermoelectric materials obtained in Examples 1-1 to 1-7 and 2-1 to 2-5 have increased Seebeck coefficients at the same charge density of the thermoelectric materials obtained in Comparative Example 1, and the Seebeck coefficients are understood to be increased due to the distortion of the electronic density of states provided by substituting and/or doping with Mn or Fe.

As described above, according to the one or more of the above embodiments, a thermoelectric material has an improved power factor due to distortion of the electronic density of states and may exhibit improved thermoelectric conversion efficiency according to the increase in the power factor. A thermoelectric module including the thermoelectric material may be used in a general-purpose cooling device, such as refrigerant-free refrigerator or an air-conditioner, or used for waste heat power generation, thermoelectric nuclear power generation for military and aerospace applications, or in a micro-cooling system.

It should be understood that the exemplary embodiments described herein shall be considered in a descriptive sense only and not for purposes of limitation. Descriptions of features, advantages, or aspects within each embodiment shall be considered as available for other similar features, advantages, or aspects in other embodiments.

**Claims**

1. A thermoelectric material comprising a composition of Formula 1:

   Formula 1 $\qquad$ $(Bi_{1-x-z}Sb_xA_z)_u(Te_{1-y}Se_y)_w$,

   wherein A is a transition metal, $0 \leq x < 1$, $0 \leq y \leq 1$, $0.005 < z \leq 0.02$, $1.8 \leq u \leq 2.2$, and $2.8 \leq w \leq 3.2$.

2. The thermoelectric material of claim 1, wherein an electronic density of states is distorted when compared to an electronic density of states of a thermoelectric material not comprising the component A.

3. The thermoelectric material of claim 1 or 2, wherein the component A is at least one selected from Ni, Zn, Sc, Y, Ti, Zr, Hf, V, Nb, Ta, Cr, Mo, W, Mn, Fe, Co, and Re.

**4.** The thermoelectric material of claim 3, wherein the component A is at least one selected from Mn and Fe.

**5.** The thermoelectric material of any of claims 1-4, having a power factor of 35 $\mu$W/cm·K$^2$ or more at 300 K.

**6.** The thermoelectric material of any of claims 1-5, in the form of a sintered body or a powder.

**7.** The thermoelectric material of any of claims 1-6, wherein the component A is doped in the thermoelectric material.

**8.** The thermoelectric material of any of claims 1-7, having a charge density in a range of $1 \times 10^{19}$ cm$^{-3}$ to $10 \times 10^{19}$ cm$^{-3}$ at 300 K.

**9.** A thermoelectric element comprising the thermoelectric material of any of claims 1-8.

**10.** A thermoelectric module comprising:

a first electrode;
a second electrode; and
the thermoelectric element of claim 9 between the first electrode and the second electrode.

**11.** A thermoelectric apparatus comprising:

a heat supply source; and
a thermoelectric module,

wherein the thermoelectric module comprises:

a thermoelectric element which absorbs heat from the heat supply source,
a first electrode which contacts the thermoelectric element, and
a second electrode which faces the first electrode and contacts the thermoelectric element,
wherein the thermoelectric element comprises the thermoelectric material of any of claims 1-8.

**12.** A method of manufacturing a thermoelectric material, the method comprising:

providing a combination comprising Bi, Sb, A, Te, and optionally Se in a molar ratio suitable to provide a composition of Formula 1:

$$\text{Formula 1} \qquad (Bi_{1-x-z}Sb_xAz)_u(Te_{1-y}Se_y)_w,$$

wherein A is a transition metal, $0 \leq x < 1$, $0 \leq y \leq 1$, $0.005 < z \leq 0.02$, $1.8 \leq u \leq 2.2$, and $2.8 \leq w \leq 3.2$; and
thermally treating the combination to manufacture the thermoelectric material.

**13.** The method of claim 12, further comprising
pulverizing a product of the treating to form a powder, and
densifying the powder to manufacture the thermoelectric material.

**Patentansprüche**

**1.** Thermoelektrisches Material, umfassend eine Zusammensetzung von Formel 1:

$$\text{Formel 1} \qquad (Bi_{1-x-z}Sb_xA_z)_u(Te_{1-y}Se_y)_w,$$

wobei A ein Übergangsmetall, $0 \leq x < 1$, $0 \leq y \leq 1$, $0{,}005 < z \leq 0{,}02$, $1{,}8 \leq u \leq 2{,}2$ und $2{,}8 \leq w \leq 3{,}2$ ist.

**2.** Thermoelektrisches Material nach Anspruch 1, wobei eine elektronische Dichte von Zuständen im Vergleich zu einer elektronischen Dichte von Zuständen eines thermoelektrischen Materials, das nicht die Komponente A umfasst, verzerrt ist.

3. Thermoelektrisches Material nach Anspruch 1 oder 2, wobei die Komponente A mindestens eines aus Ni, Zn, Sc, Y, Ti, Zr, Hf, V, Nb, Ta, Cr, Mo, W, Mn, Fe, Co und Re ist.

4. Thermoelektrisches Material nach Anspruch 3, wobei die Komponente A mindestens eine aus Mn und Fe ausgewählte ist.

5. Thermoelektrisches Material nach einem der Ansprüche 1 bis 4 mit einem Leistungsfaktor von 35 $\mu$W/cm·K$^2$ oder mehr bei 300 K.

6. Thermoelektrisches Material nach einem der Ansprüche 1 bis 5 in Form eines Sinterkörpers oder eines Pulvers.

7. Thermoelektrisches Material nach einem der Ansprüche 1 bis 6, wobei die Komponente A in dem thermoelektrischen Material dotiert ist.

8. Thermoelektrisches Material nach einem der Ansprüche 1 bis 7 mit einer Ladungsdichte in einem Bereich von $1\times10^{19}$ cm$^{-3}$ bis $10\times10^{19}$ cm$^{-3}$ bei 300 K.

9. Thermoelektrisches Element, umfassend das thermoelektrische Material nach einem der Ansprüche 1 bis 8.

10. Thermoelektrisches Modul, umfassend:

eine erste Elektrode,
eine zweite Elektrode und
das thermoelektrische Element von Anspruch 9 zwischen der ersten Elektrode und der zweiten Elektrode.

11. Thermoelektrische Vorrichtung, umfassend:

eine Wärmeversorgungsquelle und
ein thermoelektrisches Modul,

wobei das thermoelektrische Modul Folgendes umfasst:

ein thermoelektrisches Element, das Wärme von der Wärmeversorgungsquelle aufnimmt,
eine erste Elektrode, die das thermoelektrische Element berührt, und
eine zweite Elektrode, die der ersten Elektrode zugewendet ist und das thermoelektrische Element berührt,
wobei das thermoelektrische Element das thermoelektrische Material nach einem der Ansprüche 1 bis 8 umfasst.

12. Verfahren der Herstellung von thermoelektrischem Material, das Verfahren umfassend:

Bereitstellen einer Kombination, die Bi, Sb, A, Te und gegebenenfalls Se in einem Molverhältnis umfasst, das geeignet ist, eine Zusammensetzung von Formel 1 zu liefern:

Formel 1 $(Bi_{1-x-z}Sb_xA_z)_u(Te_{1-y}Se_y)_w$,

wobei A ein Übergangsmetall, $0 \leq x < 1$, $0 \leq y \leq 1$, $0{,}005 < z \leq 0{,}02$, $1{,}8 \leq u \leq 2{,}2$ und $2{,}8 \leq w \leq 3{,}2$ ist, und thermisches Behandeln der Kombination, um das thermoelektrische Material herzustellen.

13. Verfahren nach Anspruch 12, ferner umfassend
das Pulverisieren eines Produkts der Behandlung zur Bildung eines Pulvers und
das Verdichten des Pulvers, um das thermoelektrische Material herzustellen.

**Revendications**

1. Matériau thermoélectrique comprenant une composition de formule 1 :

Formule 1 $(Bi_{1-x-z}Sb_xA_z)_u(Te_{1-y}Se_y)_w$,

dans laquelle A représente un métal de transition, $0 \le x < 1$, $0 < y \le 1$, $0,005 < z \le 0,02$, $1,8 \le u \le 2,2$, et $2,8 \le w \le 3,2$.

**2.** Matériau thermoélectrique selon la revendication 1, la densité électronique d'états étant faussée lorsqu'elle est comparée à une densité électronique d'états d'un matériau thermoélectrique ne comprenant pas le composant A.

**3.** Matériau thermoélectrique selon la revendication 1 ou 2, ledit composant A étant au moins un élément choisi parmi Ni, Zn, Sc, Y, Ti, Zr, Hf, V, Nb, Ta, Cr, Mo, W, Mn, Fe, Co et Re.

**4.** Matériau thermoélectrique selon la revendication 3, ledit composant A étant au moins un élément choisi parmi Mn et Fe.

**5.** Matériau thermoélectrique selon l'une quelconque des revendications 1 à 4, présentant un facteur de puissance supérieur ou égal à 35 $\mu$W/cm.K$^2$ à 300 K.

**6.** Matériau thermoélectrique selon l'une quelconque des revendications 1 à 5, sous la forme d'un corps fritté ou d'une poudre.

**7.** Matériau thermoélectrique selon l'une quelconque des revendications 1 à 6, ledit composant A étant dopé dans le matériau thermoélectrique.

**8.** Matériau thermoélectrique selon l'une quelconque des revendications 1 à 7, présentant une densité de charge comprise dans la plage de $1 \times 10^{19}$ cm$^{-3}$ à $10 \times 10^{19}$ cm$^{-3}$ à 300 K.

**9.** Elément thermoélectrique comprenant le matériau thermoélectrique selon l'une quelconque des revendications 1 à 8.

**10.** Module thermoélectrique comprenant :

une première électrode ;
une seconde électrode ; et
l'élément thermoélectrique selon la revendication 9 entre la première électrode et la seconde électrode.

**11.** Appareil thermoélectrique comprenant :

une source d'alimentation de chaleur ; et
un module thermoélectrique,

ledit module thermoélectrique comprenant :

un élément thermoélectrique qui absorbe la chaleur provenant de la source d'alimentation de chaleur,
une première électrode qui est en contact avec l'élément thermoélectrique, et
une seconde électrode qui fait face à la première électrode et est en contact avec l'élément thermoélectrique,
ledit élément thermoélectrique comprenant le matériau thermoélectrique selon l'une quelconque des revendications 1 à 8.

**12.** Procédé de fabrication d'un matériau thermoélectrique, le procédé comprenant :

la fourniture d'une combinaison comprenant Bi, Sb, A, Te et éventuellement Se dans un rapport molaire approprié pour fournir une composition de formule 1 :

$$\text{Formule 1} \qquad (Bi_{1-x-z}Sb_xA_z)_u(Te_{1-y}Se_y)_w,$$

dans laquelle A représente un métal de transition, $0 \le x < 1$, $0 \le y \le 1$, $0,005 < z \le 0,02$, $1,8 \le u \le 2,2$, et $2,8 \le w \le 3,2$ ; et
le traitement thermique de la combinaison pour fabriquer le matériau thermoélectrique.

**13.** Procédé selon la revendication 12 comprenant en outre
la pulvérisation d'un produit du traitement pour former une poudre, et
la densification de la poudre pour fabriquer le matériau thermoélectrique.

FIG. 1

# FIG. 2

ABSORB HEAT

p-TYPE

n-TYPE

GENERATE HEAT

APPLY VOLTAGE

# FIG. 3

# FIG. 4

FIG. 5

FIG. 6

FIG. 7

# FIG. 8

FIG. 9

FIG. 10

## REFERENCES CITED IN THE DESCRIPTION

**Patent documents cited in the description**

- US 55726381 B

- CN 101082114 A

**Non-patent literature cited in the description**

- **SHEN et al.** *Journal of Inorganic Materials,* 2010, vol. 25 (6), 583-587